# FASCICULE DE BREVET EUROPEEN

(11) **EP 4 268 277 B1**
(45) Date de publication et mention de la délivrance du brevet: **18.12.2024**
(21) Numéro de dépôt: 21844291.1
(22) Date de dépôt: 22.12.2021
(51) Int. Cl.: H01L 23/498, H01L 23/00, H01L 21/48

(54) **DISPOSITIF À TIGE D'INSERT DE CONNEXION ÉLECTRIQUE SEMI-ENTERRÉE**
VORRICHTUNG MIT EINEM HALBEINGEBETTETEN SCHAFT FÜR EINEN ELEKTRISCHEN VERBINDUNGSEINSATZ
DEVICE WITH A SEMI-EMBEDDED ELECTRICAL CONNECTION INSERT STEM

(30) Priorité: 22.12.2020 FR 2013975
(43) Date de publication de la demande: 01.11.2023
(73) Titulaire: Commissariat à l'Energie Atomique et aux Energies Alternatives, 75015 Paris (FR)
(72) Inventeur: RAPHOZ, Natacha, 38054 GRENOBLE Cedex 09 (FR); CAPLET, Stéphane, 38054 GRENOBLE Cedex 09 (FR); PERAY, Patrick, 38054 GRENOBLE Cedex 09 (FR)
(74) Mandataire: Hautier IP
(86) Numéro de dépôt international: PCT/EP2021/087194
(87) Numéro de publication internationale: WO 2022/136497

(56) Documents cités:
- EP-A1- 3 171 395
- WO-A1-2015/030670
- WO-A2-2004/093100
- US-A1- 2010 164 117

## Description

### DOMAINE TECHNIQUE DE L'INVENTION

La présente invention concerne le domaine de l'assemblage de dispositifs électroniques et plus particulièrement le domaine de la microélectronique, cet assemblage permettant un raccordement électrique et mécanique d'éléments électriques de composants. L'invention trouve pour application avantageuse, mais non limitative, la fabrication de dispositifs microélectroniques. Par dispositif microélectronique, on entend tout type de dispositif réalisé avec les moyens de la microélectronique. Ces dispositifs englobent notamment, en plus des dispositifs à finalité purement électronique, des systèmes micromécaniques ou électromécaniques ainsi que des dispositifs optiques ou optoélectroniques (écrans matriciels, puces laser...). Il peut s'agir de micro écrans à LEDs, de capteurs dans le domaine du visible ou de l'infrarouge.

Du point de vue des méthodes de fabrication, l'invention s'adresse particulièrement à la formation d'interconnexions entre deux dispositifs microélectroniques par une technologie d'insertion. Elle est avantageusement compatible avec des composants présentant un faible pas d'implantation, notamment inférieur à 5 µm.

Elle permet une hybridation par l'assemblage d'éléments se complétant dans un système final ; ces éléments peuvent être par exemple un circuit de lecture à base de silicium et un circuit de détection ou d'affichage. L'assemblage réalise une connexion à la fois mécanique et électrique.

### ETAT DE LA TECHNIQUE

Les systèmes microélectroniques sont de complexité croissante ce qui implique un nombre croissant d'interconnexions électriques entre les composants. Il est historiquement connu de reporter des composants sur d'autres composants par le biais de « bossages de brasure » (« solder bumps » en anglais) servant de connecteurs à la fois pour la liaison mécanique et la continuité électrique, et permettant d'atteindre une certaine densité de connexions. Intrinsèquement, cette technologie impose la réalisation de cycles thermiques à des températures généralement supérieures à 200°C qui peuvent être pénalisantes pour les choix techniques à faire, voire être incompatibles avec certains composants.

On connaît aussi des techniques consistant à former, sur l'un des dispositifs à assembler, des inserts électriquement conducteurs généralement sous forme de clous car présentant un caractère allongé. L'autre des dispositifs à assembler comprend des plots électriquement conducteurs. Le matériau des plots est choisi plus plastique que celui des inserts. À l'assemblage, au moins un clou est placée en vis-à-vis d'un plot et une pression mécanique est exercée de sorte à insérer la ou les tiges dans le plot. Un avantage de ce procédé est qu'il est réalisable à température ambiante, comme celui des inserts sous forme de microtubes. Par exemple, les plots peuvent être à base d'alliage d'aluminium et de cuivre alors que les inserts sont par exemple à base de tungstène. Cette technique d'hybridation demande une certaine force à l'insertion pour laquelle on atteint actuellement des limites, en particulier pour l'hybridation de grandes matrices. De plus, le pas des éléments de connexion est difficile à réduire, ce qui pénalise la densité accessible via cette technique.

On connaît aussi, de la publication brevet FR 2866753 A1, un assemblage employant de telles tiges en coopération avec des plots conducteurs au contact desquels les tiges sont placées. Les tiges surplombent une face du dispositif qu'elles équipent. La fabrication de telles tiges s'avère compliquée. Le résultat n'est pas optimisé mécaniquement, de sorte que la mise en oeuvre de cette technologie pour une interconnexion par insertion dans des plots n'est pas satisfaisante.

Les documents de brevet US 2010164117 A1, EP 3171395 A1 et WO 2004093100 A2 peuvent également être cités comme représentant l'état général de la technique des assemblages de dispositifs électroniques.

Un objet de la présente invention est donc de proposer une technique améliorée pour former des éléments de connexion sous forme de tiges.

Les autres objets, caractéristiques et avantages de la présente invention apparaîtront à l'examen de la description suivante et des dessins d'accompagnement. Il est entendu que d'autres avantages peuvent être incorporés.

### RESUME DE L'INVENTION

Pour atteindre cet objectif, selon un mode de réalisation, on prévoit un dispositif microélectronique comprenant un substrat exposé sur une face du dispositif, le substrat comprenant au moins un élément électriquement conducteur, et un organe de raccordement électrique en continuité électrique avec l'élément et comprenant au moins une tige faisant saillie sur la face du dispositif.

Avantageusement, ce dispositif est tel que l'organe de raccordement comprend une portion d'ancrage inorganique recouvrant l'élément et que la tige comprend une portion enterrée dans la portion d'ancrage suivie d'une portion saillante sur la face du dispositif.

Ainsi, les tiges sont ancrées dans la couche diélectrique ce qui leur assure une résistance mécanique plus importante que les inserts, tels des microtubes, rencontrés jusqu'à présent. Alors qu'il existe un préjugé général tendant à penser que les parties de connexion doivent être des éléments rapportés strictement en saillie à la surface des dispositifs, on propose ici une solution basée sur une portion enterrée des parties de connexion, alors sous forme de tiges.

Un autre aspect concerne un système avec un dispositif tel que décrit précédemment et un dispositif microélectronique complémentaire comprenant au moins un élément complémentaire électriquement conducteur et un plot qui est raccordé électriquement à l'élément complémentaire et qui est exposé sur une face du dispositif complémentaire, l'au moins une tige étant insérée dans le plot.

Un autre aspect est relatif à un procédé de fabrication d'un dispositif microélectronique comprenant un substrat exposé sur une face du dispositif, le substrat comprenant au moins un élément électriquement conducteur, et un organe de raccordement électrique en continuité électrique avec l'élément et comprenant au moins une tige faisant saillie sur la face du dispositif, caractérisé en ce qu'il comprend :
- une fourniture ou une fabrication du substrat comprenant l'élément recouvert d'une portion d'ancrage inorganique et comprenant un via doté d'une première extrémité et une deuxième extrémité opposée à la première extrémité, le via traversant la portion d'ancrage de sorte à ce que la deuxième extrémité affleure à la surface de la portion d'ancrage,
- un enlèvement seulement partiel de la portion d'ancrage configuré pour supprimer une partie seulement de l'épaisseur de la portion d'ancrage en laissant une partie résiduelle de la portion d'ancrage, le via formant alors la tige avec une partie du via dégagée relativement à la portion d'ancrage résiduelle pour former une portion saillante et une partie du via préservée dans la portion d'ancrage résiduelle pour former une portion enterrée.

Un autre aspect est relatif à un procédé de fabrication d'un système comprenant le dispositif micro-électronique et le dispositif micro-électronique complémentaire. Ces deux dispositifs sont raccordés électriquement. L'au moins une tige du dispositif microélectronique est insérée dans un plot du dispositif micro-électronique complémentaire.

Selon un exemple, la tige est formée avec au moins un premier tronçon et un deuxième tronçon se suivant selon sa dimension en hauteur, le premier tronçon ayant une section transversale à la dimension en hauteur plus grande que celle du deuxième tronçon.

Selon un exemple, l'enlèvement comprend une gravure de la portion d'ancrage.

On forme ainsi facilement les tiges qui vont servir d'inserts lors de l'assemblage entre deux dispositifs. Technologiquement, la création des tiges est parfaitement maîtrisable en ayant recours aux méthodes d'élaboration de vias traversant des substrats. On détourne ici la vocation de ces méthodes de fabrication, qui concernent habituellement des parties conductrices s'étendant uniquement dans l'épaisseur des substrats, pour former des inserts ayant une portion exposée de manière saillante sur la face du dispositif, cette portion exposée pouvant même être une partie majoritaire de la hauteur de la tige ainsi fabriquée.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La figure 1 représente un exemple de configuration de substrat sur la base duquel la fabrication de tiges de connexion peut être réalisée.
Les figures 2 à 14 représentent des étapes avantageusement successives de réalisation de tiges.
Les figures 15A et 15B donnent une variante de réalisation.
Les figures 16 à 26 fournissent un exemple d'étapes avantageusement successives pour la fabrication de tiges suivant un autre mode de réalisation.
Les figures 27A à 27C montrent trois possibilités indicatives de forme de section de tiges.
Les figures 28 à 33 fournissent un exemple d'étapes avantageusement successives pour la fabrication de tiges suivant un autre mode de réalisation.
Les figures 34 à 36 donnent une autre variante de réalisation.
Les figures 37 à 43 fournissent un exemple d'étapes avantageusement successives pour la fabrication de tiges suivant un autre mode de réalisation.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs ne sont pas représentatives de la réalité.

### DESCRIPTION DÉTAILLÉE DE L'INVENTION

Avant d'entamer une revue détaillée de modes de réalisation de l'invention, sont énoncées ci-après des caractéristiques optionnelles qui peuvent éventuellement être utilisées en association ou alternativement.
- la portion enterrée 1161 forme au moins 5%, éventuellement au moins 10%, d'une dimension en hauteur de la tige 116. Alternativement ou en complément, la portion enterrée peut représenter au moins 50 nm.
- la portion enterrée 1161 forme au plus 20% d'une dimension en hauteur de la tige 116.
- la portion d'ancrage 113 recouvre intégralement une face supérieure de l'élément 105. De cette façon, l'élément électriquement conducteur à raccorder se trouve enrobé dans le substrat.
- la tige 116 comprend une première extrémité au contact de l'élément 105.
- la tige 116 est électriquement conductrice. Elle peut assurer, seule ou non, le raccordement électrique de l'élément 105.
- la portion d'ancrage 131 est électriquement isolante. Elle peut servir à isoler l'élément 105, en formant un revêtement diélectrique au-dessus de l'élément 105. Une couche sous-jacente à l'élément 105, de même matériau ou non, également diélectrique, complète avantageusement cette isolation.
- la portion d'ancrage 131 est en dioxyde de silicium. Cela constitue un choix dont la fabrication est facile.
- la portion d'ancrage 131 est électriquement conductrice. Un intérêt peut être de disposer d'une plus grande surface de contact avec l'élément.
- la tige 116 est électriquement isolante et l'organe de raccordement 130 comprend un revêtement 132 électriquement conducteur au contact à la fois de la portion saillante de la tige et de la portion d'ancrage.
- le revêtement 132 couvre totalement la portion saillante.
- la dimension en hauteur de la tige 116 est supérieure à 1 µm et/ou inférieure à 3µm.
- la tige 116 comporte au moins un premier tronçon 1163 et un deuxième tronçon 1164 se suivant selon sa dimension en hauteur, le premier tronçon 1163, s'étendant éventuellement depuis l'élément, ayant une section transversale à la dimension en hauteur plus grande que celle du deuxième tronçon 1164. La forme de la section transversale du premier tronçon peut être différente de celle du deuxième tronçon. Les deux tronçons ne sont pas forcément centrés suivant la dimension en hauteur de la tige.
- la portion enterrée 1161 est entièrement comprise dans le premier tronçon 1163.
- la tige 116 présente une section transversale choisie parmi les formes suivantes : circulaire, annulaire, polygonale, en croix.
- la tige (116) est formée avec au moins un premier tronçon (1163) et un deuxième tronçon (1164) se suivant selon sa dimension en hauteur, le premier tronçon (1163) ayant une section transversale à la dimension en hauteur plus grande que celle du deuxième tronçon (1164).
- l'enlèvement comprend une gravure de la portion d'ancrage.
de préférence, l'enlèvement comprend une gravure de la portion diélectrique (102).

Il est précisé que, dans le cadre de la présente invention, le terme « sur » ou « au-dessus » ne signifie pas obligatoirement « au contact de ». Ainsi, par exemple, le dépôt d'une couche sur une autre couche, ne signifie pas obligatoirement que les deux couches sont directement au contact l'une de l'autre mais cela signifie que l'une des couches recouvre au moins partiellement l'autre en étant soit directement à son contact, soit en étant séparée d'elle par un film, encore une autre couche ou un autre élément.

Une couche peut par ailleurs être composée de plusieurs sous-couches d'un même matériau ou de matériaux différents.

On entend par un élément « à base » d'un matériau A, un élément comprenant ce matériau A uniquement ou ce matériau A et éventuellement d'autres matériaux. Par exemple, l'élément comprend un matériau A et une enveloppe configurée pour contenir l'élément A, l'enveloppe pouvant être formée d'au moins un matériau distinct du matériau A.

Un matériau est considéré comme inorganique dès lors qu'il ne s'agit pas d'un matériau carboné. Cela inclut les métaux (comme l'aluminium), les oxydes et alliages métalliques, ainsi que les matériaux semi-conducteurs ou les matériaux à base de semi-conducteur, comme le silicium, le nitrure de silicium ou le dioxyde de silicium. Les matériaux polymères à chaînes carbonées en sont exclus.

On entend par un paramètre « sensiblement égal/supérieur/inférieur à » une valeur donnée, que ce paramètre est égal/supérieur/inférieur à la valeur donnée, à plus ou moins 10% près, voire à plus ou moins 5% près, de cette valeur.

Dans la description détaillée qui suit, il pourra être fait usage de termes tels que « longitudinal », « transversal ». Ces termes doivent être interprétés relativement au substrat ou à la dimension en épaisseur des dispositifs. Ainsi, une hauteur ou une épaisseur d'un élément ou d'une couche s'entend d'une dimension selon l'épaisseur du substrat qui le porte ou le contient. Une largeur, ou encore une section ou une dimension transversale s'entend d'une dimension perpendiculaire à l'épaisseur du substrat.

Certaines parties du dispositif de l'invention peuvent avoir une fonction électrique. Certaines sont employées pour des propriétés de conduction électrique et on entend par électriquement conducteurs ou équivalents, des éléments formés d'au moins un matériau ayant une conductivité suffisante, dans l'application, pour réaliser la fonction souhaitée. D'autres parties, au contraire, sont employées pour des propriétés d'isolation électrique et tout matériau ayant une résistivité suffisante pour réaliser cette isolation sont concernées et sont notamment appelées diélectriques ou électriquement isolants.

Un aspect de l'invention est le raccordement électrique d'un ou plusieurs éléments électriquement conducteurs d'un premier dispositif avec un au moins un élément électriquement conducteur, dit complémentaire, d'un autre dispositif, assemblé avec le premier. Le terme « élément électriquement conducteur » s'entend de toute partie d'un dispositif microélectronique présentant pour le moins une fonction électrique. De préférence, l'élément est le dernier niveau métal d'interconnexion d'un composant électronique. Avantageusement, l'élément a une géométrie planaire, dirigée perpendiculairement à la dimension en épaisseur du substrat. Il peut s'agir d'un motif électriquement conducteur implémenté dans un dispositif microélectronique, d'une extrémité d'un via traversant, d'une ligne de distribution électrique enterrée dans le dispositif, d'un connecteur associé à un composant plus complexe ayant par exemple une fonction optique émissive ou réceptrice de lumière, ou électronique, tel qu'un transistor, ou un capteur, une puce, un circuit intégré, un composant électromécanique ou optoélectronique.

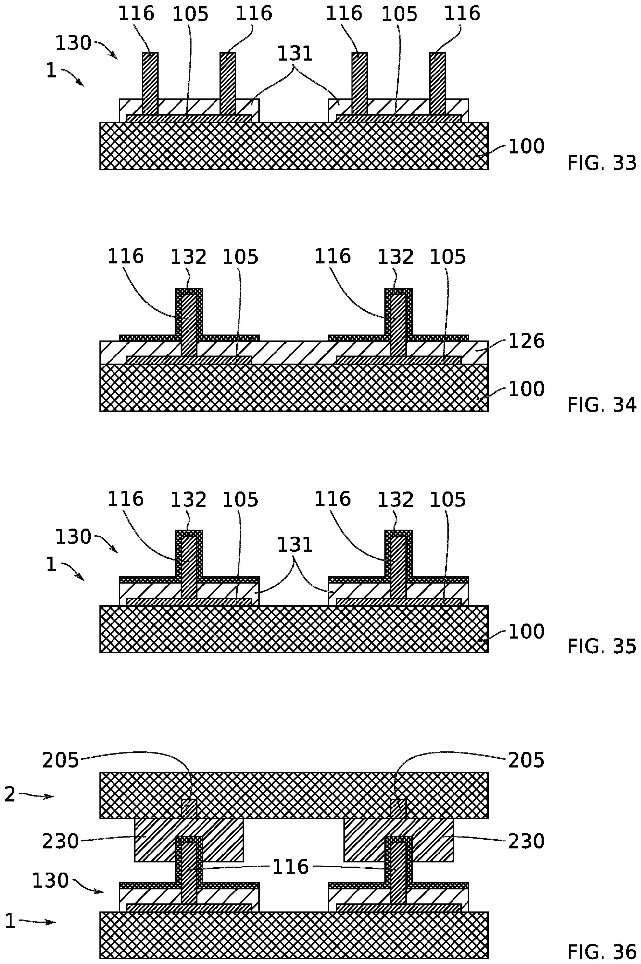

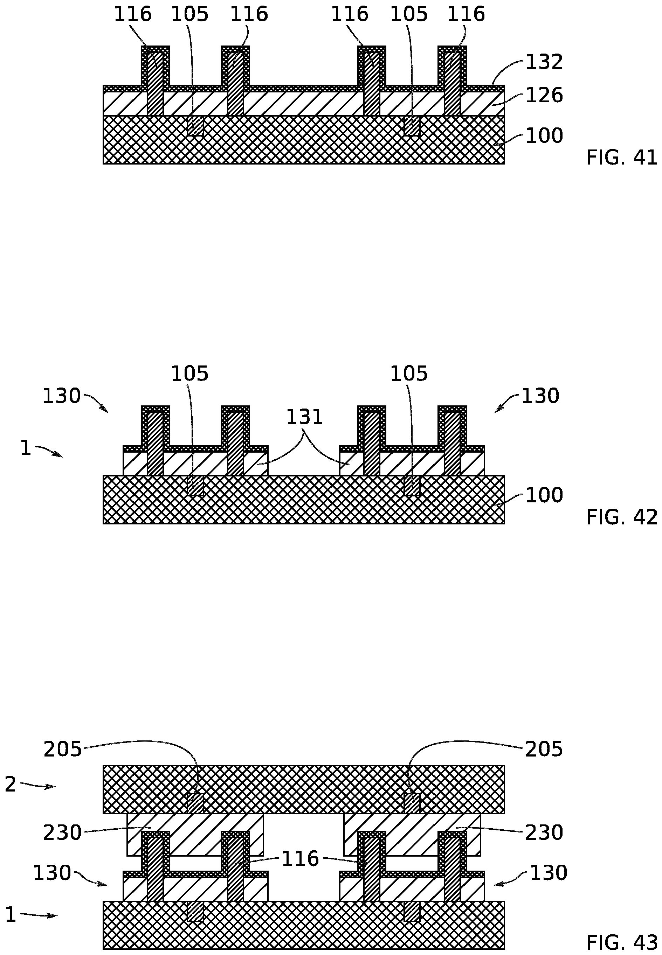

On décrit ci-après des exemples de réalisation de l'invention avec des étapes de procédé de fabrication. D'une manière générale, l'objectif est de réaliser un dispositif microélectronique 1 comprenant un organe de raccordement électrique 130 d'un élément 105 électriquement conducteur, l'organe de raccordement 130 comprenant lui-même au moins une tige de connexion qui comporte une portion enterrée dans une portion d'ancrage 131 et une portion saillante sur une face du dispositif. La portion saillante a pour le moins vocation de servir de relief d'insertion dans un organe de connexion complémentaire, typiquement sous forme d'un plot 230 plus déformable plastiquement que la tige 116, le plot étant avantageusement ductile. Les figures 36 et 43 montrent deux exemples pour raccorder ainsi l'élément électriquement conducteur 105 et un élément électriquement conducteur complémentaire 205 d'un dispositif micro-électronique complémentaire 2.

De préférence, la portion enterrée de la tige 116 est au contact de la portion d'ancrage sur toute la dimension en hauteur de ladite portion enterrée ; l'effet technique est que l'on profite d'un ancrage sur toute la hauteur disponible, jusqu'en haut de la portion d'ancrage.

Dans certains modes de réalisation, la ou les tiges 116 servent à la conduction électrique en permettant de raccorder l'élément 105 à l'extérieur. Dans ce cas, elles seront en matériau électriquement conducteur. Dans d'autres situations, l'invention met en oeuvre un raccordement électrique par d'autres moyens, et en particulier en utilisant une portion d'ancrage 131 en matériau électriquement conducteur ainsi qu'un revêtement 132 recouvrant au moins une partie de la surface de la portion saillante de la tige tout en étant, par ailleurs, au contact de la portion d'ancrage 131.

Suivant une possibilité, la portion d'ancrage 131 est formée en un seul matériau, et de préférence déposée en une seule couche.

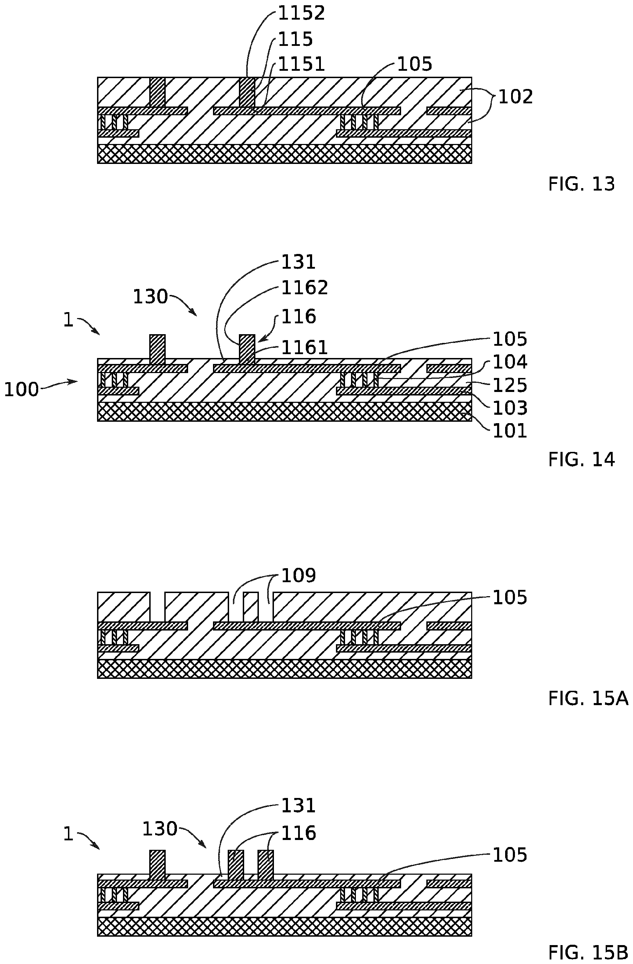

Une première possibilité de réalisation de l'organe de raccordement 130 est par exemple visible à la figure 14 et correspond à un mode de réalisation dans lequel la tige 116 réalise, ou pour le moins participe à réaliser, le raccordement électrique de l'élément 105. On y représente un dispositif réalisé sur la base d'un substrat 100 qui comporte par exemple une couche de base 101, qui peut être faite de silicium, au sein d'une couche diélectrique 125, un ou plusieurs éléments 105 ayant une fonction électrique. Par exemple, la couche diélectrique peut être réalisée à base ou en dioxyde de silicium. Bien entendu, il pourra s'agir d'autres matériaux servant d'isolation électrique, et par exemple un oxyde ou d'autres matériaux semi-conducteurs, comme du germanium, ou encore un nitrure de silicium ou un nitrure d'autres matériaux semi-conducteurs, comme du germanium. Des matériaux non semi-conducteurs sont aussi utilisables, comme des oxydes métalliques, tels que l'Al2O3. D'une manière générale, comme indiqué précédemment, une couche peut présenter plusieurs sous-couches. Les matériaux peuvent être différents pour chacune des sous-couches.

Le cas représenté est purement illustratif. Il montre une structure tridimensionnelle avec différents niveaux d'éléments. Dans cet exemple, deux niveaux sont présents, avec des éléments électriques 103 de premier niveau raccordés par un ou plusieurs vias 104 à des éléments105 de deuxième niveau. On a précédemment donné des exemples de types d'éléments qu'il est possible de mettre en oeuvre. Dans l'illustration, il peut typiquement s'agir de lignes de distribution électrique au travers du dispositif.

Généralement, un ou plusieurs éléments 105 méritent une connexion à un ou plusieurs éléments complémentaires 205 d'un autre dispositif 2. À cet effet, selon l'invention, de tels éléments peuvent être présents de manière enterrée dans le dispositif, et particulièrement au sein de la couche diélectrique 125. De préférence, l'élément 105 n'est pas du tout exposé à la face du dispositif, et cela permet typiquement une isolation électrique/magnétique efficace de cet élément 105. Cependant, pour le raccorder à l'extérieur, le dispositif de l'invention comporte une plusieurs tiges 116.

Le vocable « tige » s'entend d'un élément allongé en ce sens qu'il présente, suivant une direction, une dimension supérieure à celle qu'il présente dans les autres directions ; cette direction, ici appelée dimension en hauteur, est orientée suivant l'épaisseur du substrat 100. La section transversale d'une tige 116 n'est pas limitée, mais il pourra par exemple s'agir de tiges cylindriques, avantageusement de section circulaire. Par exemple, la hauteur complète d'une tige peut être supérieure à 1 µm et/ou inférieure à 3 µm. Le rapport de forme entre la plus grande dimension d'une tige dans sa section transversale et la dimension en hauteur peut être supérieure à 20%, voire être supérieure à 30 %, et/ou être inférieure à 60 %, voire être inférieure à 50%.

De manière caractéristique, une tige 116 comporte deux portions qui se suivent selon la direction en hauteur de la tige 116. Une première portion, appelée portion enterrée 1161 s'étend, dans le cas de figure de la figure 14, à l'intérieur de la couche diélectrique 125 qui réalise la portion d'ancrage 131 autour de la tige 116. L'extrémité inférieure de la tige est ici en contact avec la face supérieure d'un élément 105 de sorte à les mettre en continuité électrique. L'autre extrémité de la portion enterrée 1161 se situe au niveau de la face du dispositif, et elle est suivie de l'extrémité inférieure d'une portion saillante 1162 de la tige 116. Cette deuxième portion fait saillie au-dessus de la face du dispositif de sorte à former un relief sur cette dernière.

Suivant une possibilité, la hauteur de la portion enterrée 1161 correspond à au moins 5%, voire à au moins 10% de la hauteur totale de la tige 116 et/ou à au plus 20% de la hauteur totale de la tige 116. Alternativement ou en complément, la hauteur de la portion enterrée 1161 peut être d'au moins, ou supérieure à, 50 nm.

Suivant une possibilité, la hauteur totale de la tige est supérieure ou égale à 500 nm, voire à 700 nm, et est typiquement supérieure ou égale à 1 µm.

La structure de chaque tige 116 est configurée pour assurer une conduction électrique suivant sa hauteur, de sorte à réaliser la fonction d'interconnexion de l'élément 105 avec un élément complémentaire extérieure. À cette fin, une tige 116 peut comprendre une ou plusieurs portions électriquement conductrices. Par exemple, la tige 116 présente un motif métallique, par exemple à base de tungstène ou en tungstène, qui s'étend sur toute la hauteur.

Le nombre de tiges 116 présentes dans le dispositif n'est pas limité, ni même le nombre de tiges 116 affectées au raccordement d'un élément 105 donné. Ainsi, alors que la figure 14 fournit un exemple d'une tige 116 par élément 105, la figure 15B montre qu'un élément 105 peut être doté d'une pluralité de tiges 116. Ce cas reste schématique et un nombre bien plus important de tiges peut être mis en oeuvre. En particulier, suivant une option de l'invention, on utilise une matrice de tiges 116 pour raccorder un élément 105. Cela permet de répartir la fonction électrique et mécanique entre différentes tiges 116. Le pas peut être inférieur à 5 µm.

Suivant un exemple, le dispositif complémentaire 2 auquel le dispositif est à raccorder comprend, pour chaque élément, au moins un plot 230 apte à coopérer avec la ou les tiges 116. De préférence, cette coopération s'effectue par insertion des tiges 116 dans le plot 230, avec, de préférence, une plastification de la matière du plot lors de cette insertion. Plus particulièrement, la portion saillante 1162 de chaque tige 116 est pressée sur le plot, ce qui conduit à l'insertion de cette portion dans le plot de 130. Avantageusement, les formes et dimensions de la portion saillante sont adaptées, notamment en termes de rapport de forme et de hauteur, pour permettre son insertion dans le plot 230.

De préférence, le rapport de forme de la portion saillante de la tige est configuré pour permettre son insertion dans le plot 230. Suivant une possibilité, le rapport de forme, entre la plus grande dimension de la portion saillante d'une tige dans sa section transversale et la dimension en hauteur, peut être supérieure à 20%, voire être supérieure à 30 %, et/ou être inférieure à 60 %, voire être inférieure à 50%.

Avantageusement, la hauteur de la portion saillante 1162 est supérieure ou égale à 300 nm, voire à 500 nm, voire à 700 nm, voire à 1 µm.

On décrit maintenant une suite d'étapes potentielles pour parvenir au dispositif représenté à la figure 14.

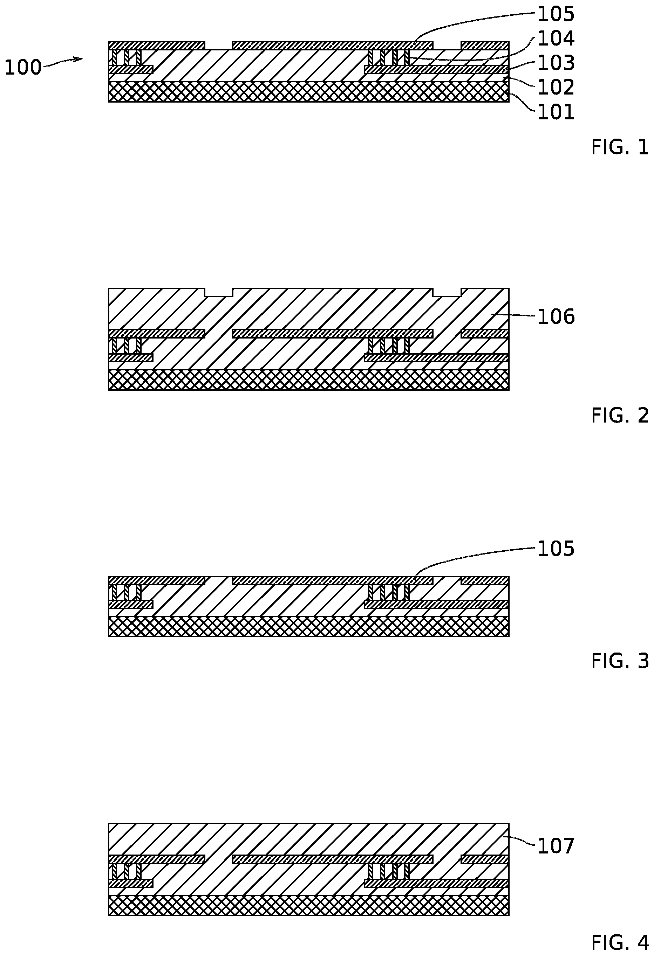

La figure 1 représente un substrat 100 pouvant servir de point de départ à la construction des tiges 116.

Le substrat 100 comprend la couche de base 101, une portion diélectrique 102 qui pourra servir à former une partie de la couche diélectrique 125 finale dont une partie encadrant la tige sert de portion d'ancrage 131, et des éléments 103,105. Dans cet exemple, les éléments 103 sont raccordés à l'élément 105 de niveau supérieur par des vias 104. Les éléments 105 sont exposés à la surface du substrat 100. Ils peuvent être réalisés par un dépôt métallique suivi d'une lithographie et d'une gravure permettant de définir des motifs réalisant les éléments 105. Par exemple, le métal déposé peut être un alliage comprenant du titane, de l'aluminium, du cuivre...

En figure 2, un dépôt 106 a été produit pour accroître la hauteur de la portion diélectrique, par exemple avec du dioxyde de silicium. Ce dépôt peut être exécuté par un procédé de type dépôt chimique en phase vapeur avec un plasma à haute densité, connue sous l'acronyme HDP CVD, avec du SiH₄ comme précurseur. On peut par exemple réaliser un comblement d'une hauteur d'environ 1 µm.

Ensuite, on a opéré un retrait par polissage, tel qu'un polissage chimique et mécanique en utilisant la surface des éléments 105 comme couche d'arrêt, de sorte à obtenir une surface plane, correspondant à la situation de la figure 3.

Sur la base de cet état de surface optimisé, on opère un nouveau dépôt 107 de matériau diélectrique qui permet d'enterrer les éléments 105, comme le montre la figure 4. Par exemple, il peut s'agir d'un dépôt de dioxyde de silicium par dépôt chimique en phase vapeur assisté par plasma, connu sous l'acronyme PECVD, à partir de tétraéthoxysilane (connue sous l'acronyme TEOS). Là encore, une épaisseur de l'ordre du micromètre est possible. Typiquement, on réalise une épaisseur de déposition correspondant à la hauteur de tige souhaitée in fine.

Sur cette base, on va réaliser des trous servant à former des vias, qui vont euxmêmes devenir des tiges 116.

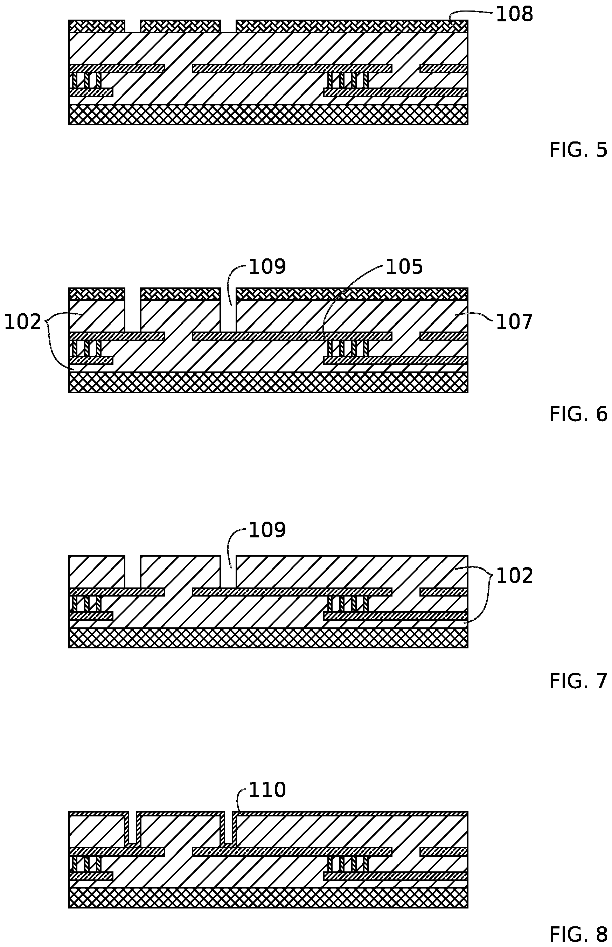

Ainsi, la figure 5 montre la formation d'un masque 108, pouvant être mis en oeuvre par des techniques de photolithographie habituelles. Ce masque comporte des motifs permettant de définir, en creux, des zones d'exposition de la portion diélectrique au niveau desquelles des trous 109 vont être réalisés (au droit de l'élément 105 à équiper de tiges), typiquement par une gravure, typiquement par plasma, du matériau du dépôt 107, comme l'indique la figure 6. Le matériau de la face de l'élément 105 sert de couche d'arrêt à cette gravure. Le masque est ensuite retiré, pour obtenir le résultat de la figure 7.

Débute alors la formation du via proprement dit. Cette dernière peut commencer par le dépôt d'une couche 110 pouvant servir de couche de fond du via. Cette couche peut servir de couche d'adhérence (par exemple en Ti) et/ou de barrière de diffusion (par exemple en TiN). Il peut s'agir d'un dépôt physique en phase vapeur (de l'acronyme PVD).

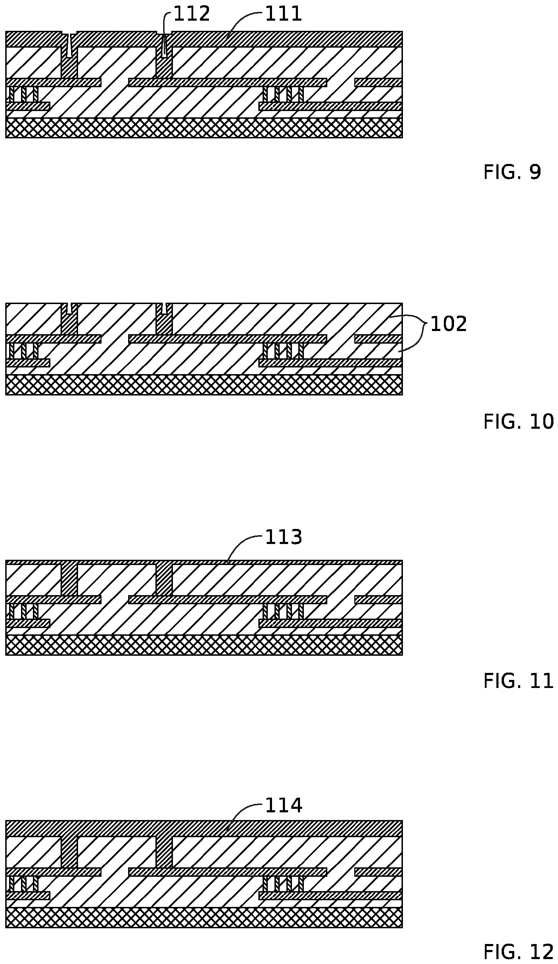

Un remplissage plus conséquent est ensuite opéré en un ou plusieurs cycles, de sorte à optimiser le remplissage. Ce cas est représenté à la figure 9 avec un dépôt d'une couche 111, par exemple par dépôt chimique en phase vapeur en une ou plusieurs fois, suivi, en figure 10, par un polissage auquel succède un deuxième dépôt 113, par exemple toujours par voie chimique en phase vapeur, de sorte à combler d'éventuels vides 112 qui auraient pu être initiés lors du premier remplissage comme c'est le cas en figure 11. Le remplissage peut être effectué avec un matériau à base de tungstène, pour au moins l'un des dépôts, de préférence le premier. Éventuellement, le deuxième dépôt peut être réalisé en TiTiN.

En figure 12, un dernier dépôt 114 a été opéré, par exemple par CVD, par exemple en tungstène. Il comble éventuellement des trous résiduels.

Après un polissage, avec arrêt sur le haut du via 115, on parvient à la situation de la figure 13, au niveau de laquelle une extrémité 1152 du via est exposée à la surface du substrat 100 destinée à former le dispositif. Le reste de cette surface est avantageusement défini par la couche diélectrique dérivant de la portion diélectrique 102. L'autre extrémité du via, portant la référence 1151, est raccordée à l'élément 105.

On parvient ensuite à la configuration décrite en référence à la figure 14 par un retrait d'une partie superficielle de la portion diélectrique 102. Il peut s'agir d'une gravure pleine plaque. Cette gravure est sélective en ce sens qu'elle élimine le matériau diélectrique tout en préservant le matériau des via formant dorénavant les tiges 116. On peut maîtriser au temps l'épaisseur du matériau diélectrique gravé. On peut utiliser une gravure par plasma avec du TEOS.

Par exemple, on peut s'arranger pour obtenir une gravure de 80% de l'épaisseur de matériau diélectrique surmontant l'élément 105, de sorte à préserver une hauteur de 20% servant à enterrer la portion 1161 des tiges 116.

Pour parvenir à la réalisation représentée à la figure 15B, il suffit simplement de former une pluralité de trous 109 au droit d'un élément 105 donné et de réaliser les phases de définition de vias correspondant à cette pluralité.

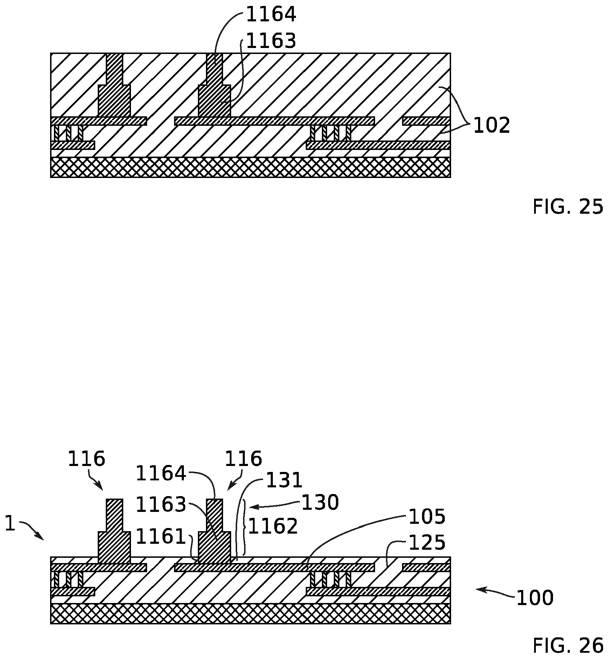

Un autre exemple de configuration de tige est donné à la figure 26. De préférence, l'organe de raccordement électrique 130 y comprend toujours au moins une tige 116 électriquement conductrice. Comme précédemment, la portion d'ancrage 130 peut être électriquement isolante. Cela permet notamment d'utiliser une couche recouvrant complètement la face du dispositif pour y réaliser la portion d'ancrage 130. On verra plus loin que cette disposition n'est cependant aucunement limitative.

Comme précédemment, sur la base d'un substrat 100, comprenant des éléments 105 à connecter, on a formé les tiges 116 qui comportent chacune une portion enterrée 1161 dans une couche diélectrique 125 et une portion saillante 1162 formant une saillie au-dessus de la couche 125.

Cependant, dans ce cas, la tige 116 comporte une variation de section avec, suivant sa hauteur, un premier tronçon 1163 suivi d'un deuxième tronçon 1164 de section plus réduite. De préférence, les tronçons se suivent suivant la direction en hauteur de la tige en étant centrés sur la direction longitudinale de la tige. Les tronçons peuvent avoir une section transversale de même forme ou non. Les tiges ainsi formées comportent une base plus large, offrant une résistance mécanique supérieure, et ce d'autant plus que la portion enterrée de la tige se situe au niveau du premier tronçon. L'ancrage de chaque tige dans la portion d'ancrage 131 réalisée dans la couche diélectrique 125 n'en est que meilleur. Un avantage alternatif ou complémentaire est de permettre une plus grande hauteur de tige, grâce à une portion basale, le premier tronçon, de plus grande dimension latérale.

Par exemple, on peut réaliser un premier tronçon 1163 d'une hauteur sensiblement de 1 µm, pour une plus grande largeur de section transversale sensiblement de 1 µm ; comme précédemment, la section peut être circulaire et le diamètre est alors par exemple sensiblement de 1 µm.

Pour le deuxième tronçon 1164, il peut par exemple avoir une section transversale 50% moins large que celle du premier tronçon 1163. Sa hauteur peut être sensiblement la même.

Exemple, on peut ainsi former une tige 116 d'une hauteur de sensiblement 1,5 à 2 µm.

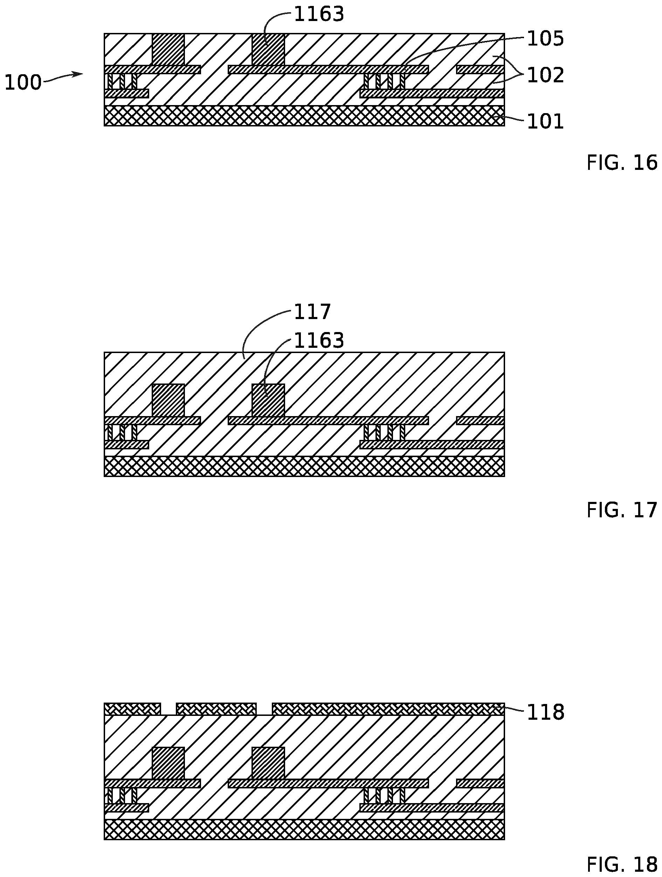

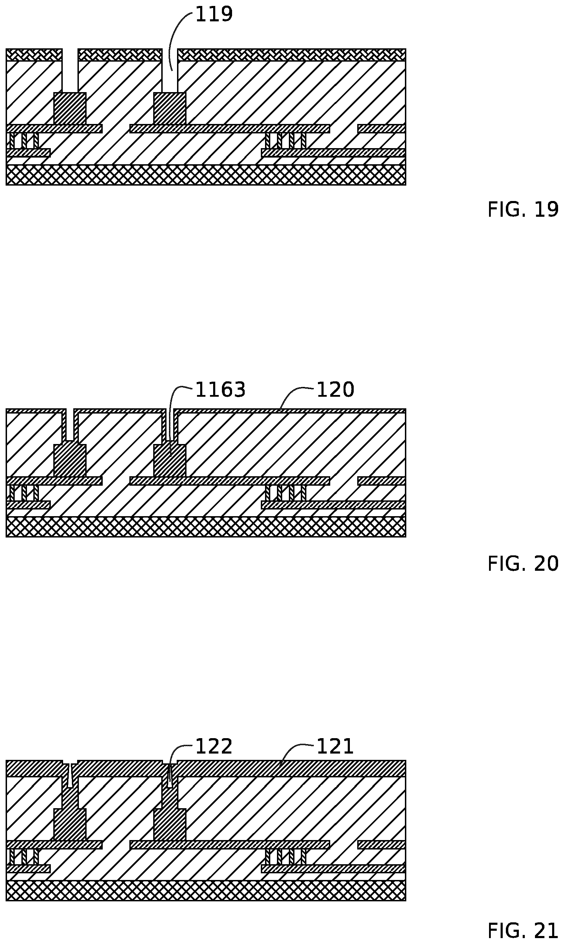

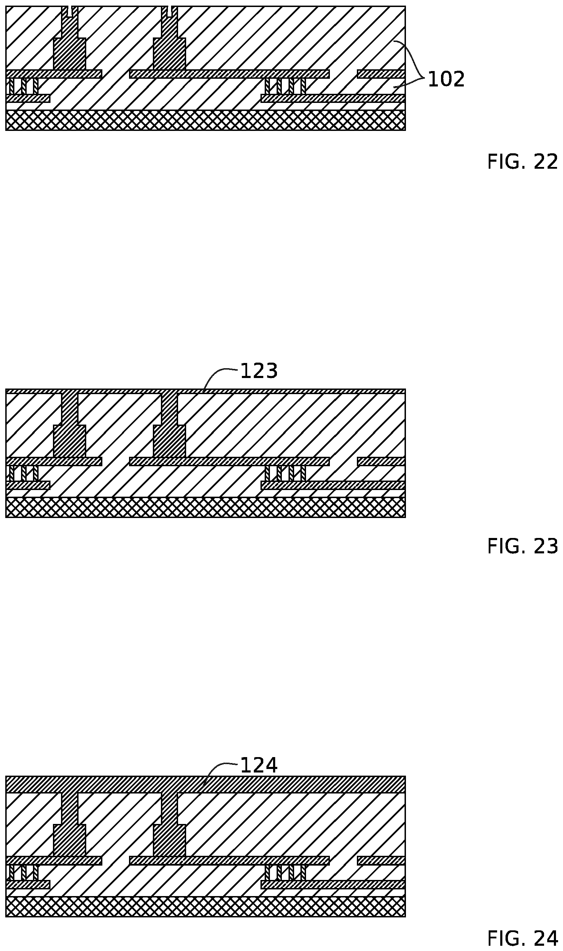

Pour parvenir à un tel résultat, des étapes de procédé sont présentées de la figure 16 à la figure 26. La situation de la figure 16 correspond au résultat qui avait été obtenu dans l'exemple précédent, à la figure 13. Ici, pour l'exemple, la partie de via formée, réalisant le premier tronçon 1163, est plus large que précédemment. Sur cette base, plutôt que de dégager une partie du via pour le révéler à la surface de la couche diélectrique comme décrit dans l'exemple précédent, une deuxième portion de via, correspondant au deuxième tronçon 1164 est produite.

Ainsi, la figure 17 montre un nouveau dépôt 117 de matériau diélectrique pour recouvrir le premier tronçon 1163 sur une hauteur correspondant à la hauteur du deuxième tronçon à réaliser. Des techniques de dépôt précédemment décrites peuvent convenir.

La succession d'étapes qui suit, à partir de la figure 18, est potentiellement très similaire à la succession d'étapes présentées en référence aux figures 5 à 13. En effet, la couche issue du dépôt 117 peut ensuite faire l'objet d'une définition de trous par un masquage 118, d'une gravure des trous 119 (on peut utiliser l'extrémité supérieure du premier tronçon 1163 comme couche d'arrêt de cette gravure), puis de dépôts successifs 120, 121, 123, 124 qui peuvent être similaires respectivement aux dépôts 110,111,113,114.

Comme précédemment, une partie du via est révélée sur la couche 125, de préférence par une gravure permettant d'enlever du matériau diélectrique de la couche 102 à partir de sa surface.

Suivant une option, les via sont définis dans un substrat issu d'un premier site industriel. Ils sont ensuite fournis sur un autre site, pour subir le dégagement partiel définissant la portion enterrée et la portion exposée des tiges, puis, de préférence sur le même site, on assure l'assemblage avec un autre dispositif complémentaire. Bien entendu, l'ensemble des étapes peut être réalisé sur un même site.

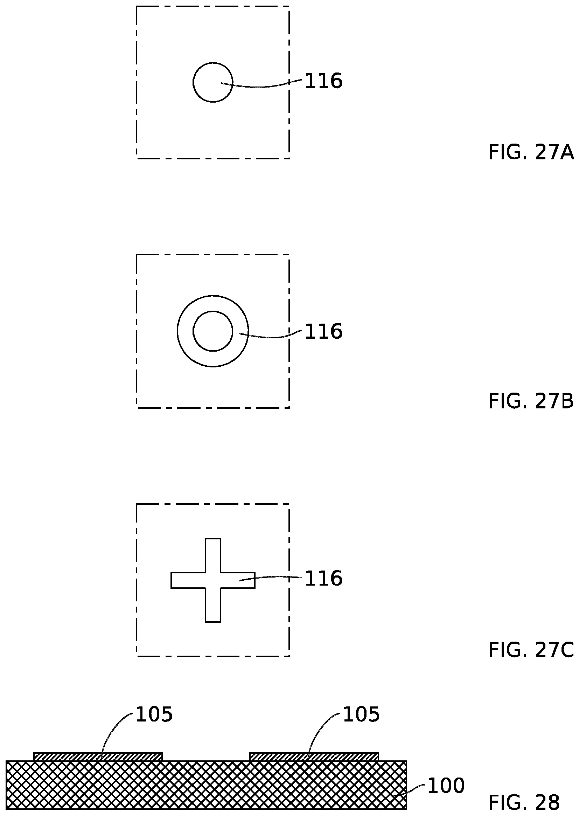

Les figures 27A à 27C fournissent trois illustrations indicatives de section transversale que peut adopter une tige 116. Dans la situation de la figure 27A, le trou a été conformé pour réaliser une tige 116 de section circulaire pleine ; la figure 27B donne un autre exemple avec une section annulaire, le centre de cette section pouvant être vide en formant alors un microtube ou rempli d'un autre matériau, par exemple moins conducteur mais plus rigide que le matériau de la tige 116 elle-même. Un troisième cas indicatif est révélé par la figure 27C avec une forme en croix. Ces dispositions ne sont pas limitatives et on peut notamment recourir à une section polygonale, par exemple carrée, ou à toute autre forme.

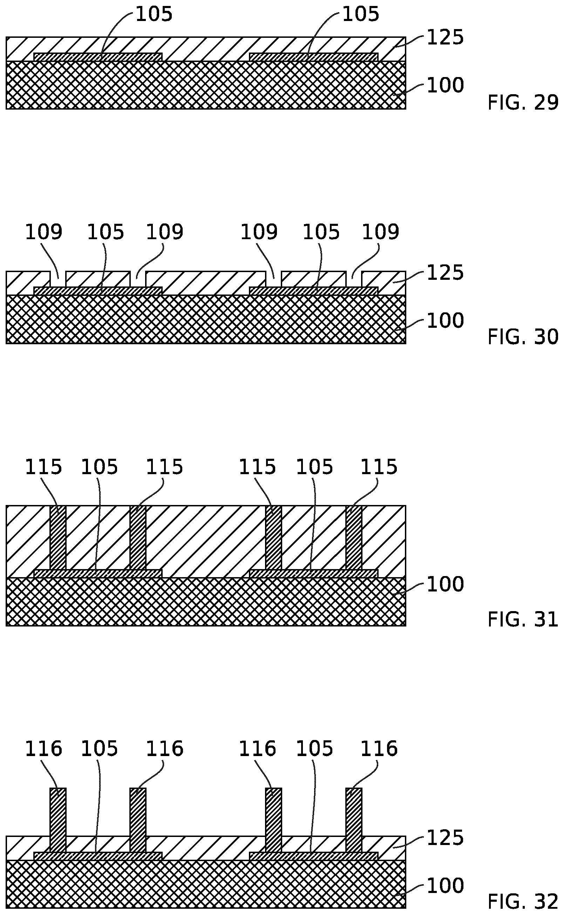

Le mode de réalisation correspondant aux figures 28 à 33 est proche des précédents. On part d'un substrat 100 portant un ou plusieurs éléments électriquement conducteurs 105. Comme précédemment, les éléments 105 sont enrobés dans une couche, ici encore une couche diélectrique 125 par exemple. Cependant, on verra qu'il pourrait s'agir d'une couche électriquement conductrice. Cette couche peut former une hauteur de 1 à 4 µm au-dessus de la face supérieure de l'élément 105. Globalement, on peut suivre les étapes précédemment décrites pour former des trous 109 dans la couche 125, puis des vias 115 destinés à former les tiges 116 représentées à la figure 32. D'ailleurs, la configuration obtenue à cette figure correspond sensiblement à l'exemple de la figure 15B hormis l'absence d'éléments 103 de niveau sous-jacent de conduction électrique, les éléments pouvant toujours être présents ou non. D'autre part, comme le montrent les figures 30 31, on a ici tiré profit d'une construction en deux temps (voire en plus que deux temps) des vias pour obtenir une hauteur plus importante avec un rapport de forme favorisant la hauteur. Contrairement à l'exemple obtenu en figure 26, on a dans cet exemple, purement indicatif, une continuité des différents tronçons de vias, sans variation de section transversale.

De manière différente, la figure 33 montre que l'on définit des motifs dans la couche 125 de sorte à délimiter latéralement la portion d'ancrage 131 de l'organe de raccordement 130 autour des tiges 116. De préférence, cette délimitation préserve un enrobage complet de l'élément 105, si bien qu'il est entièrement enterré, c'est-à-dire que sa surface est entièrement non exposée sur la face du dispositif. Comme évoqué précédemment, cette configuration permet en outre d'utiliser pour la portion d'ancrage 131 des matériaux électriquement conducteurs, en prenant soin d'isoler électriquement la portion d'ancrage 131 relativement au reste de la face du dispositif.

La délimitation latérale de la portion d'ancrage 131 peut être opérée par gravure de sorte à former un détourage.

Une autre variante ressort des figures 35 à 36:un revêtement 132 de nature électriquement conductrice, est réalisé au-dessus de la tige 116 et de la face exposée de la couche servant à former la portion d'ancrage 131. Ici, pour l'exemple, cette couche est sous forme d'une couche électriquement conductrice 126. Pour le moins, on s'arrange pour que le revêtement 132 forme une partie conductrice en continuité avec la portion d'ancrage 131 sous-jacente, cette partie conductrice se conformant par ailleurs autour de la partie saillante de la tige 116 de sorte à bénéficier d'une conduction électrique avec un plot 230 lors du raccordement d'un dispositif microélectronique complémentaire 2.

Comme précédemment, on peut détourer la portion d'ancrage 131 pour isoler électriquement chacun des organes de raccordement électrique 130 comme le montre la figure 35.

La figure 36 présente la solution de raccordement électrique entre les dispositifs 1 et 2 avec cette solution. Le plot 230 est lui-même raccordé électriquement à l'élément électriquement conducteur complémentaire 205 si bien qu'on réalise l'hybridation par ce biais.

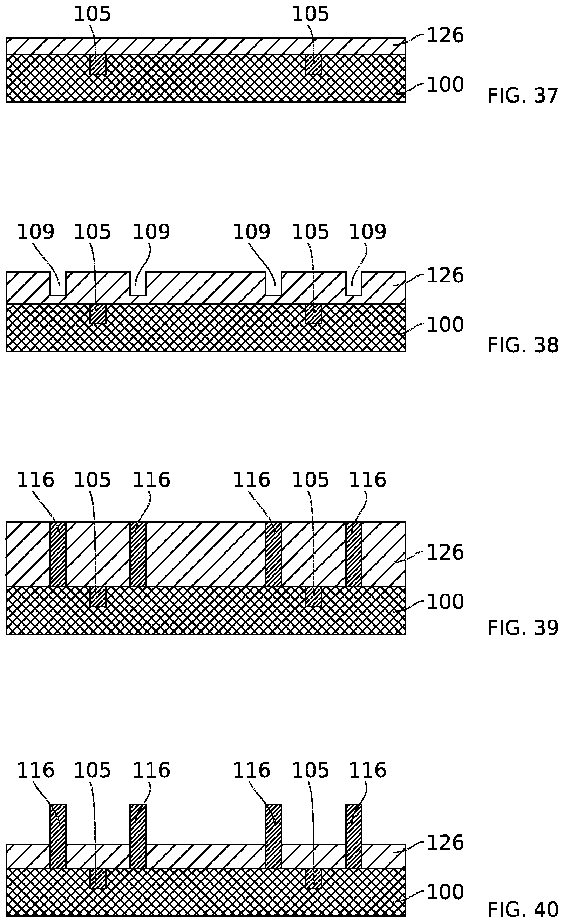

Les figures 37 à 43 présentent un autre mode de réalisation reflétant notamment qu'il n'est pas nécessaire que la ou les tiges 116 soient au contact de l'élément 105.

En particulier, la forme mâle de la tige (connue également sous les termes microinsert, micropointe ou clou) a ici pour le moins vocation mécanique pour l'assemblage avec le plot 230, si bien que la ou les tiges 116 ne sont pas nécessairement électriquement conductrices non plus dans cette configuration.

Les éléments 105 d'un substrat 100 sont d'abord recouverts par une couche électriquement conductrice 126 comme à la figure 37. En figure 38, comme précédemment, des trous sont réalisés dans cette couche dans la perspective de fabriquer des vias. Ces trous peuvent être réalisés de manière à traverser toute l'épaisseur de la couche 126, ou non. Toujours comme précédemment, on peut réaliser ces trous, et les tronçons de via associés, de manière successive, pour augmenter la hauteur finale de tige 116, et donc aussi le rapport de forme. Dans ce cas de figure, la localisation des tiges 116 est configurée pour ne pas venir au contact de l'élément 105, ou pour le moins pour ne pas le recouvrir totalement. Ce dernier reste surmonté par la couche électriquement conductrice 126.

Ainsi, dans la configuration de la figure 40, un élément 105 se trouve encadré par deux tiges 116 qui présentent, comme précédemment, une portion enterrée dans une couche, ici la couche conductrice 126.

On tire également profit d'un revêtement électriquement conducteur 132, dont le dépôt est illustré à la figure 41, pour recouvrir par un conducteur électrique la partie saillante des tiges, en continuité avec la couche 126.

L'étape suivante est similaire à celle discutée pour la figure 35, les organes de raccordement 130 présents sur la face du dispositif étant individualisés pour les isoler les uns des autres. Dans ce cas, c'est donc uniquement au travers du matériau électriquement conducteur de la portion d'ancrage 131 que la continuité électrique s'opère jusque par le dessus des parties saillantes des tiges 116. Éventuellement, les tiges 116 peuvent être réalisées de manière à encadrer le composant. On peut utiliser au moins une paire de tiges, voire une pluralité de tiges, par exemple organisées en cercle, autour de l'élément 105.

D'une manière générale, le nombre de tiges n'est pas limité et tous les exemples donnés ci-dessus sont utilisables avec au moins une tige, éventuellement deux tiges, voire plus de deux tiges, pour un organe de raccordement 130 considéré. Le nombre d'organes de raccordement 130 disponibles à la surface du dispositif microélectronique n'est pas non plus limité. Éventuellement, plusieurs organes 130 peuvent permettre un raccordement d'un même élément 105, même s'il est préféré qu'ils servent à raccorder électriquement des éléments 105 distincts.

A moins qu'il en soit explicitement disposé autrement dans la présente description, chaque caractéristique d'un mode de réalisation précédemment décrit peut être mise en oeuvre, mutatis mutandis, dans les autres modes de réalisation. Par exemple, des tiges 116 à plusieurs tronçons sont réalisables dans toutes les situations, de même que les différentes formes de section transversale de tige 116 présentées. De même, on a présenté différentes variantes de nature électriquement conductrice ou isolante pour les tiges et les portions d'ancrage et, à chaque fois que cela est possible, toutes les combinaisons réalisables de ces natures électriques peuvent être mises en oeuvre.

Au surplus, plusieurs matériaux, de préférence de nature électrique (conductrice ou diélectrique) identique, peuvent être mis en oeuvre pour former les parties de l'organe de raccordement 130. Par exemple, une portion d'ancrage 131 peut comporter un empilement de couches de matériaux différents, comme un oxyde de semi-conducteur suivi d'un nitrure de semi-conducteur, ou inversement.

Suivant une possibilité, lorsqu'une tige comporte plusieurs tronçons, ils peuvent être de nature électrique différente si tant est que leur configuration relative à la portion d'ancrage permet, malgré tout, une continuité électrique depuis l'élément 105 jusqu'à la surface de la portion saillante 1162. Alternativement, ou en combinaison, avec ce cas, la portion d'ancrage peut comporter, en empilement, des sous-couches de nature électrique différente si tant est que leur configuration relative à la tige permet toujours cette continuité électrique.

## Revendications

1. Système comprenant :
- un dispositif microélectronique comprenant un substrat (100) exposé sur une face du dispositif, le substrat (100) comprenant au moins un élément (105) électriquement conducteur, et un organe de raccordement électrique (130) en continuité électrique avec l'élément (105) et comprenant au moins une tige (116) faisant saillie sur la face du dispositif,
- et un dispositif microélectronique complémentaire (2) comprenant au moins un élément complémentaire (205) électriquement conducteur et un plot (230) qui est raccordé électriquement à l'élément complémentaire (205) et qui est exposé sur une face du dispositif complémentaire (2),
système dans lequel l'organe de raccordement (130) comprend une portion d'ancrage (131) inorganique recouvrant l'élément (105) et en ce que la tige (116) comprend une portion enterrée (1161) dans la portion d'ancrage (131) suivie d'une portion saillante (1162) sur la face du dispositif, la portion saillante (1162) de l'au moins une tige (116) étant insérée dans le plot (230).

2. Système selon la revendication précédente, dans lequel la portion saillante (1162) est une partie majoritaire d'une dimension en hauteur de la tige (116), et dans lequel, de préférence, la portion enterrée (1161) forme au moins 5% d'une dimension en hauteur de la tige (116) et/ou la portion enterrée (1161) forme au plus 20% d'une dimension en hauteur de la tige (116).

3. Système selon l'une quelconque des revendications précédentes, dans lequel la dimension en hauteur de la tige (116) est supérieure à 1 µm et/ou inférieure à 3 µm, et de préférence dans lequel la portion saillante (1162) de la tige (116) est supérieure à 300 nm.

4. Système selon l'une quelconque des revendications précédentes, dans lequel la tige (116) présente un rapport de forme, entre sa plus grande dimension dans sa section transversale et sa dimension en hauteur, supérieur à 20 %.

5. Système selon l'une quelconque des revendications précédentes, dans lequel la portion d'ancrage (131) recouvre intégralement une face supérieure de l'élément (105).

6. Système selon l'une quelconque des revendications précédentes, dans lequel la tige (116) comprend une première extrémité au contact de l'élément (105).

7. Système selon la revendication précédente, dans lequel la tige (116) est électriquement conductrice.

8. Système selon la revendication précédente, dans lequel la portion d'ancrage (131) est électriquement isolante, de préférence en dioxyde de silicium.

9. Système selon l'une quelconque des revendications 1 à 6, dans lequel la portion d'ancrage (131) est électriquement conductrice.

10. Système selon la revendication précédente, dans lequel la tige (116) est électriquement isolante et dans lequel l'organe de raccordement (130) comprend un revêtement (132) électriquement conducteur au contact à la fois de la portion saillante de la tige et de la portion d'ancrage.

11. Système selon la revendication précédente, dans lequel le revêtement (132) couvre totalement la portion saillante.

12. Système selon l'une quelconque des revendications précédentes, dans lequel la tige (116) comporte au moins un premier tronçon (1163) et un deuxième tronçon (1164) se suivant selon sa dimension en hauteur, le premier tronçon (1163) ayant une section transversale à la dimension en hauteur plus grande que celle du deuxième tronçon (1164), et dans lequel, de préférence,
la portion enterrée (1161) est au moins partiellement formée par le premier tronçon (1163), et/ou dans lequel, de manière préférentielle,
la tige (116) présente une section transversale choisie parmi les formes suivantes : circulaire, annulaire, polygonale, en croix.

13. Procédé de fabrication d'un système comprenant un dispositif microélectronique (1) comprenant un substrat (100) exposé sur une face du dispositif microélectronique, le substrat (100) comprenant au moins un élément (105) électriquement conducteur, et un organe de raccordement électrique (130) en continuité électrique avec l'élément (105) et comprenant au moins une tige (116) faisant saillie sur la face du dispositif microélectronique, le procédé comprenant :
- une fourniture ou une fabrication du substrat (100) comprenant l'élément (105) recouvert d'une portion d'ancrage inorganique (131) et comprenant un via (115) doté d'une première extrémité et une deuxième extrémité opposée à la première extrémité, le via (115) traversant la portion d'ancrage (131) de sorte à ce que la deuxième extrémité affleure à la surface de la portion d'ancrage (131),
- un enlèvement seulement partiel de la portion d'ancrage (131) configuré pour supprimer une partie seulement de l'épaisseur de la portion d'ancrage (131) en laissant une partie résiduelle de la portion d'ancrage (131), le via (115) formant alors la tige (116) avec une partie du via (115) dégagée relativement à la portion d'ancrage résiduelle (131) pour former une portion saillante (1162) et une partie du via (115) préservée dans la portion d'ancrage résiduelle (131) pour former une portion enterrée (1161),
- un raccordement électrique du dispositif microélectronique avec un dispositif microélectronique complémentaire (2) comprenant au moins un élément complémentaire (205) électriquement conducteur et un plot (230) qui est raccordé électriquement à l'élément complémentaire (205) et qui est exposé sur une face du dispositif complémentaire (2), la portion saillante (1162) de l'au moins une tige (116) étant insérée dans le plot (230).

14. Procédé selon la revendication précédente, dans lequel la tige (116) est formée avec au moins un premier tronçon (1163) et un deuxième tronçon (1164) se suivant selon sa dimension en hauteur, le premier tronçon (1163) ayant une section transversale à la dimension en hauteur plus grande que celle du deuxième tronçon (1164).

15. Procédé selon l'une quelconque des deux revendications précédentes, dans lequel l'enlèvement comprend une gravure de la portion d'ancrage et, de préférence,
comprenant une plastification du plot (230) quand la portion saillante (1162) de l'au moins une tige (116) est insérée.

## Patentansprüche

1. System, umfassend:
- eine mikroelektronische Vorrichtung, die ein Substrat (100) umfasst, das auf einer Fläche der Vorrichtung freiliegt, wobei das Substrat (100) mindestens ein Element (105) umfasst, das elektrisch leitfähig ist, und ein Anschlussorgan in elektrischer Kontinuität mit dem Element (105), das mindestens einen Schaft (116) umfasst, der an der Fläche der Vorrichtung vorsteht,
- und eine komplementäre mikroelektronische Vorrichtung (2), die mindestens ein elektrisch leitfähiges komplementäres Element (205) und einen Klotz (230) umfasst, der elektrisch an das komplementäre Element (205) angeschlossen ist und der auf einer Fläche der komplementären Vorrichtung (2) freiliegt,
System, bei dem das Anschlussorgan (130) einen anorganischen Verankerungsabschnitt (131) umfasst, der das Element (105) abdeckt, und der Schaft (116) einen vergrabenen Abschnitt (1161) in dem Verankerungsabschnitt (131) umfasst, gefolgt von einem vorstehenden Abschnitt (1162) auf der Fläche der Vorrichtung, wobei der vorstehende Abschnitt (1162) des mindestens einen Schafts (116) in den Klotz (230) eingefügt ist.

2. System nach dem vorstehenden Anspruch, wobei der vorstehende Abschnitt (1162) ein Großteil eines Höhenmaßes des Schafts (116) ist, und wobei der vergrabene Abschnitt (1161) bevorzugt mindestens 5 % eines Höhenmaßes des Schafts (116) bildet, und/oder der vergrabene Abschnitt (1161) höchstens 20 % eines Höhenmaßes des Schafts (116) bildet.

3. System nach einem der vorstehenden Ansprüche, wobei das Höhenmaß des Schafts (116) größer als 1 µm und/oder kleiner als 3 µm ist, und wobei der vorstehende Abschnitt (1162) des Schafts (116) bevorzugt größer als 300 nm ist.

4. System nach einem der vorstehenden Ansprüche, wobei der Schaft (116) ein Formverhältnis zwischen seinem größten Maß in dem Querschnitt und seinem Höhenmaß größer als 20 % umfasst.

5. System nach einem der vorstehenden Ansprüche, wobei der Verankerungsabschnitt (131) eine obere Fläche des Elements (105) integral abdeckt.

6. System nach einem der vorstehenden Ansprüche, wobei der Schaft (116) ein erstes Ende in Kontakt mit dem Element (105) umfasst.

7. System nach dem vorstehenden Anspruch, wobei der Schaft (116) elektrisch leitfähig ist.

8. System nach dem vorstehenden Anspruch, wobei der Verankerungsabschnitt (131) elektrisch isolierend ist, bevorzugt aus Siliziumdioxid.

9. System nach einem der Ansprüche 1 bis 6, wobei der Verankerungsabschnitt (131) elektrisch leitfähig ist.

10. System nach dem vorstehenden Anspruch, wobei der Schaft (116) elektrisch isolierend ist, und wobei das Anschlussorgan (130) eine elektrisch leitfähige Beschichtung (132) in Berührung sowohl mit dem vorstehenden Abschnitt des Schafts als auch mit dem Verankerungsabschnitt umfasst.

11. System nach dem vorstehenden Anspruch, wobei der Schaft (132) den vorstehenden Abschnitt vollständig abdeckt.

12. System nach einem der vorstehenden Ansprüche, wobei der Schaft (116) mindestens einen ersten Teilabschnitt (1163) und einen zweiten Teilabschnitt (1164) umfasst, die entlang seines Höhenmaßes aufeinanderfolgen, wobei der erste Teilabschnitt (1163) einen Querschnitt an dem Höhenmaß aufweist, der größer ist als der des zweiten Teilabschnitts (1164), und wobei bevorzugt
der vergrabene Abschnitt (1161) mindestens teilweise durch den ersten Teilabschnitt (1163) gebildet ist, und/oder wobei bevorzugt
der Schaft (116) einen Querschnitt umfasst, der aus den folgenden Formen ausgewählt ist: kreisförmig, ringförmig, vieleckig, als Kreuz.

13. Verfahren zur Fertigung eines Systems, das eine mikroelektronische Vorrichtung (1) umfasst, die ein Substrat (100) umfasst, das auf einer Fläche der mikroelektronischen Vorrichtung freiliegt, wobei das Substrat (100) mindestens ein Element (105) umfasst, das elektrisch leitfähig ist, und mindestens ein elektrisches Anschlussorgan (130) in elektrischer Kontinuität mit dem Element (105), und das mindestens einen Schaft (116) umfasst, der auf der Fläche der mikroelektronischen Vorrichtung vorsteht, wobei das Verfahren Folgendes umfasst:
- eine Lieferung oder eine Fertigung des Substrats (100), das das Element (105) umfasst, das mit einem anorganischen Verankerungsabschnitt (131) abgedeckt ist, und ein Durchgangsloch (115) umfasst, das mit einem ersten Ende und einem zweiten Ende, das dem ersten Ende entgegengesetzt ist, versehen ist, wobei das Durchgangsloch (115) den Verankerungsabschnitt (131) derart durchquert, dass das zweite Ende mit der Oberfläche des Verankerungsabschnitts (131) bündig ist,
- ein lediglich teilweises Entfernen des Verankerungsabschnitts (131), das dazu konfiguriert ist, nur einen Teil der Dicke des Verankerungsabschnitts (131) zu beseitigen, indem ein restlicher Teil des Verankerungsabschnitts (131) belassen wird, wobei die Durchkontaktierung (115) dabei den Schaft (116) mit einem Teil des Durchgangslochs (115) in Bezug zu dem restlichen Verankerungsabschnitt (131) freigelegt bildet, um einen vorstehenden Abschnitt (1162) zu bilden, und einen Teil des Durchgangslochs (115), der in dem restlichen Verankerungsabschnitts (131) behalten wird, um einen vergrabenen Abschnitt (1161) zu bilden,
- und einen elektrischen Anschluss der mikroelektronischen Vorrichtung an eine komplementäre mikroelektronische Vorrichtung (2), die mindestens ein komplementäres elektrisch leitfähiges Element (205) und einen Klotz (230) umfasst, der elektrisch an das komplementäre Element (205) angeschlossen ist und auf einer Fläche der komplementären Vorrichtung (2) freigelegt ist, wobei der vorstehende Abschnitt (1162) des mindestens einen Schafts (116) in den Klotz (230) eingefügt ist.

14. Verfahren nach dem vorstehenden Anspruch, wobei der Schaft (116) mit mindestens einem ersten Teilabschnitt (1163) und einem zweiten Teilabschnitt (1164) gebildet ist, die gemäß seinem Höhenmaß aufeinanderfolgen, wobei der erste Teilabschnitt (1163) einen Querschnitt an dem Höhenmaß aufweist, der größer ist als der des zweiten Teilabschnitts (1164).

15. Verfahren nach einem der beiden vorstehenden Ansprüche, wobei das Entfernen eine Gravur des Verankerungsabschnitts umfasst und bevorzugt eine Plastifizierung des Klotzes (230) umfasst, wenn der vorstehende Abschnitt (1162) des mindestens einen Schafts (116) eingesetzt wird.

## Claims

1. System comprising:
- a microelectronic device comprising a substrate (100) exposed on a face of the device, the substrate (100) comprising at least one electrically conductive element (105), and an electrical connection member (130) in electrical continuity with the element (105) and comprising at least one rod (116) projecting over the face of the device,
- and a complementary microelectronic device (2) comprising at least one complementary electrically conductive element (205) and a terminal (230) which is electrically connected to the complementary element (205) and which is exposed on a face of the complementary device (2),
system wherein the connection member (130) comprises an inorganic anchoring portion (131) covering the element (105) and in that the rod (116) comprises a portion (1161) buried in the anchoring portion (131) followed by a portion (1162) projecting over the face of the device, the projecting portion (1162) of the at least one rod (116) being inserted in the terminal (230).

2. System according to the preceding claim, wherein the projecting portion (1162) is a main part of a dimension by height of the rod (116), and wherein, preferably, the buried portion (1161) forms at least 5% of a dimension by height of the rod (116) and/or the buried portion (1161) forms at most 20% of a dimension by height of the rod (116).

3. System according to any one of the preceding claims, wherein the dimension by height of the rod (116) is greater than 1µm and/or less than 3 µm, and preferably wherein the projecting portion (1162) of the rod (116) is greater than 300nm.

4. System according to any one of the preceding claims, wherein the rod (116) has a shape ratio, between its largest dimension in its transverse section and its dimension by height, greater than 20%.

5. System according to any one of the preceding claims, wherein the anchoring portion (131) fully covers an upper face of the element (105).

6. System according to any one of the preceding claims, wherein the rod (116) comprises a first end in contact with the element (105).

7. System according to the preceding claim, wherein the rod (116) is electrically conductive.

8. System according to the preceding claim, wherein the anchoring portion (131) is electrically insulating, preferably made of silicon dioxide.

9. System according to any one of claims 1 to 6, wherein the anchoring portion (131) is electrically conductive.

10. System according to the preceding claim, wherein the rod (116) is electrically insulating, and wherein the connection member (130) comprises an electrically conductive coating (132) in contact both with the projecting portion of the rod and of the anchoring portion.

11. System according to the preceding claim, wherein the coating (132) fully covers the projecting portion.

12. System according to any one of the preceding claims, wherein the rod (116) comprises at least one first section (1163) and one second section (1164) following one another along its dimension by height, the first section (1163) having a section transversal to the dimension by height greater than that of the second section (1164), and wherein, preferably,
the buried portion (1161) is at least partially formed by the first section (1163), and/or wherein, preferably,
the rod (116) has a transverse section chosen from among the following shapes: circular, annular, polygonal, cross.

13. Method for manufacturing a system comprising a microelectronic device (1) comprising a substrate (100) exposed on a face of the microelectronic device, the substrate (100) comprising at least one electrically conductive element (105), and an electrical connection member (130) in electrical continuity with the element (105) and comprising at least one rod (116) projecting over the face of the microelectronic device, the method comprising:
- a provision or a manufacturing of the substrate (100) comprising the element (105) covered by an inorganic anchoring portion (131) and comprising a via (115) provided with a first end and a second end opposite the first end, the via (115) passing through the anchoring portion (131), such that the second end is flush with the surface of the anchoring portion (131),
- an only partial removal of the anchoring portion (131) configured to remove only some of the thickness of the anchoring portion (131) by leaving a residual part of the anchoring portion (131), the via (115) thus forming the rod (116) with a part of the via (115) removed relative to the residual anchoring portion (131) to form a projecting portion (1162) and a part of the via (115) preserved in the residual anchoring portion (131) to form a buried portion (1161),
- an electrical connection of the microelectronic device with a complementary microelectronic device (2) comprising at least one complementary electrically conductive element (205) and a terminal (230) which is electrically connected to the complementary element (205) and which is exposed on a face of the complementary device (2), the projecting portion (1162) of the at least one rod (116) being inserted in the terminal (230).

14. Method according to the preceding claim, wherein the rod (116) is formed with at least one first section (1163) and one second section (1164) following one another along its dimension in height, the first section (1163) having a section transversal to the dimension by height greater than that of the second section (1164).

15. Method according to any one of the two preceding claims, wherein the removal comprises an etching of the anchoring portion and, preferably,
comprising a plasticising of the terminal (230) when the projecting portion (1162) of the at least one rod (116) is inserted.
